## Europäisches Patentamt
## European Patent Office
## Office européen des brevets

(11) Publication number: **0 107 931**
**B1**

# EUROPEAN PATENT SPECIFICATION

(45) Date of publication of patent specification: **18.01.89**

(51) Int. Cl.⁴: **C 25 D 5/02**

(21) Application number: **83305977.7**

(22) Date of filing: **30.09.83**

(54) Selective plating.

(30) Priority: **05.10.82 GB 8228376**

(43) Date of publication of application:
**09.05.84 Bulletin 84/19**

(45) Publication of the grant of the patent:
**18.01.89 Bulletin 89/03**

(84) Designated Contracting States:
**AT BE CH DE FR GB IT LI LU NL SE**

(56) References cited:
**EP-A-0 055 130**
**GB-A-1 447 027**
**US-A-3 257 308**
**US-A-3 658 663**

(73) Proprietor: **S.G. OWEN (NORTHAMPTON) LIMITED**
**6 Colne Road**
**Twickenham Middlesex (GB)**

(72) Inventor: **Richards, Michael Arthur**
**17 Parkfield Avenue**
**Delapre Northampton NN4 9QH (GB)**

(74) Representative: **Brown, John David et al**
**FORRESTER & BOEHMERT Widenmayerstrasse 4/I**
**D-8000 München 22 (DE)**

Courier Press, Leamington Spa, England.

# Description

This invention relates to selective plating, in particular the selective plating with electrodepositable metals and alloys such as gold of discrete components which may otherwise be difficult to plate selectively, such as integrated circuit (IC) headers.

Certain types of component are, because of their shape, difficult to plate selectively. This is particularly applicable to components in which wires pass through a conductive member but are not conductively connected thereto, where it is required to plate the ends of the wire and the surface of the conductive member surrounding the same. An example of this type of component is an IC header, which comprises a base for a semiconductor device, or a transistor can, with hermetically sealed insulated leads extending through an insulating medium such as glass or a rigid plastics material.

In the past, components of this type, in particular smaller components such as TO46 type headers, have either had the lead wires crimped together and then the whole barrel plated (a process of plating in which the components to be plated are placed in a rotating container provided with negative contacts) or the whole have been barrel plated without even crimping the ends together. Besides it being expensive to operate such processes, the wastage in gold (when gold is the plating medium) is being plated which do not require plating. This problem is exacerbated by the fact that the lead wires tend to be plated in preference to the ends of the wire and the can. In some commercial operations, this wastage of gold is so important that after assembly of the plated component the excess gold is removed from the lead wires. Also, bonding between the component and the plating medium may be poor, resulting in poor component performance, and smaller components may be damaged by barrel plating. It has been proposed to improve bonding by adding "fill" in the form of particulate steel to the plating container. However, the process of recovering gold which has been electrodeposited on the fill during plating is expensive and time consuming.

Similar problems arise with other components. For example, all military-type sockets (and pins) are normally barrel plated (all over coverage), or selectively plated by partial immersion (inside and out). In the latter case, the outer surface receives a plating thickness of the order of twice that on the inner surface, where it is actually required.

In the past, as disclosed in US—A—3,257,308, there was used an article holder including a plurality of electrode elements and accommodating a plurality of articles simultaneously. The electrode elements extended adjacent recesses for receiving the articles, the recesses being formed in a pad of resilient compressible material, positionable adjacent to the pad. The recesses included surface portions of the articles whereby only selected portions of the articles were plated. Clamping members were provided for clamping the pad and rigid plate together as a unit and for applying force thereto to press the electrode elements into firm electrical contact with the articles.

It is an object of the present invention to enable the provision of a method of selective plating a component whereby the above disadvantages may be overcome, or at least mitigated.

Accordingly, the present invention provides a method of selective plating a plurality of components, which method comprises mounting each component on a jig so that the plurality of components are fixed in position relative to one another, and then press-fitting a resilient mask having a plurality of apertures onto the components, wherein each component is located in relation to the mask by contacting the jig with the mask, so that each aperture resiliently engages a respective said component and selectively exposes a portion thereof, each aperture comprising first and second portions of respective different cross-sectional areas, a part of the respective component being engaged in the first portion, and a beading of the jig being engaged in the second portion of the aperture. Thus, a "peel-off" mask is used in which the components to be plated are press-fitted and then plated in a selective plating machine. Advantageously, the mask comprises a silicone rubber having a hardness of from 12° to 80° Shore, the hardness of the silicone rubber increasing with the size of the component. (A mask of this type will last for about 3 months when in continuous use for 8 hours per day). Additional masking may be applied to reduce even further the area of the component which is exposed to electrolyte.

The method of the present invention may be used in any suitable selective plating machine, such as the "Cresta" type machine of S. G. Owen Limited, which is in commercial use in the United Kingdom, or the "Carousel" type machine of S. G. Owen Limited, which is in commercial use in the United Kingdom and the United States of America. In all cases where Carousel, Cresta or similar machines are used the time saved by the use of the "peel-off" masks could give significant reductions in labour costs. Advantageously, each component to be plated is mounted in one of a plurality of rigidly inter-connected jigs, a metal-to-metal cathode contact being provided in each jig, for example as described and illustrated in U.K. Patent Specification No. 1,447,027, a mask having a plurality of plating apertures is press fitted to the jigs and to the components mounted therein and the whole apparatus is inverted over a plating tank in a selective plating machine (as opposed to previously proposed arrangements in which the bottom mask is a fixture in the plating machine). However, the method of the present invention could also be used in conjunction with the contactless plating technique described and illustrated in European Patent Application No.

83301946.6. Apart from the use of the "peel-off" mask of the present invention, plating is effected in the conventional manner utilizing, for example, an appropriate one of the commercially available plating solutions. A suitable current density for gold plating headers in the "Carousel" type selective plating machine is about 15 amp/dm² (1500 amp/m²) of cathode interface.

The method of the present invention can be used to plate with any electrodepositable metal or alloy. However, it is envisaged that the method will be of particular utility in plating with relatively expensive metals such as gold. For example, in the case of TO46 type headers, which are normally all over barrel plated, it is estimated that a cost saving in gold of the order of US$1,600 per 100,000 units could be obtained using the method of the present invention (gold at US$414 per Troy oz). In the case of military-type sockets, a saving of the order of US$300 per 100,000 units could be obtained, relative to partial immersion plating.

Thus, the present invention provides an alternative to the barrel plating process, particularly for small headers such as TO46 types, with the cost advantages of selectivity. The present invention can also enable processing to be carried out more quickly than hitherto, resulting in further cost savings.

For a better understanding of the present invention, and to show how the same may be put into effect, reference will now be made, by way of example, to the accompanying drawings, in which:

Figure 1 is a perspective view of a first mask in accordance with the invention,

Figure 2 is a vertical sectional view of a jig holding a header and having the mask of Figure 1 press fitted thereto,

Figure 3 is a perspective view of a second mask in accordance with the invention,

Figure 4 is a vertical sectional view of military-type sockets press fitted into the mask of Figure 3, and

Figure 5 is a view on arrow V in Figure 4.

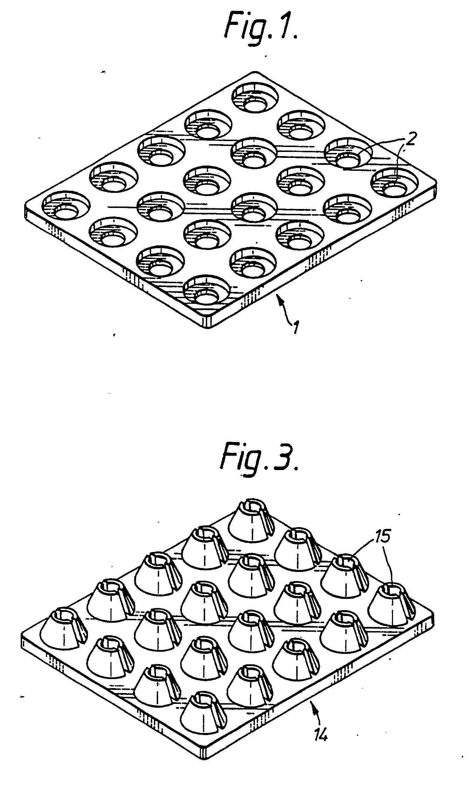

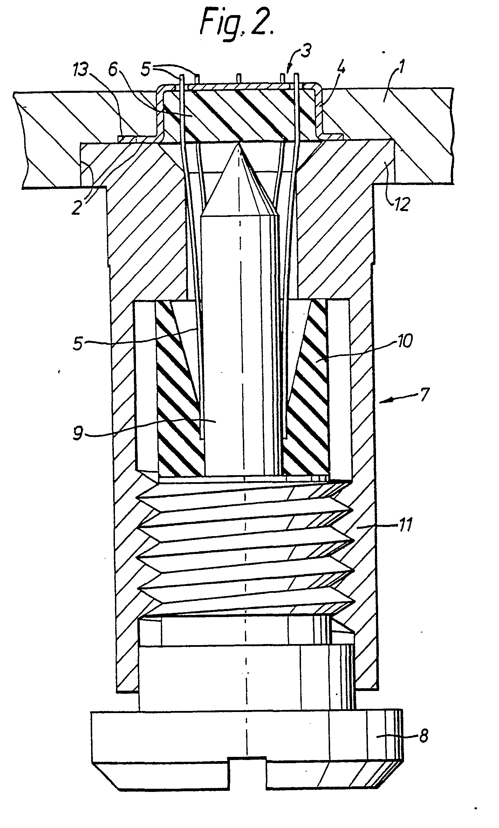

Referring now to Figures 1 and 2 of the drawings, the first mask 1 comprises a silicone rubber (supplied by Dow Corning) having a hardness of about 40° shore and is provided with a plurality of plating apertures 2. The header 3 comprises a cap 4 and lead wires 5 of conductive material and a glass disc 6 in which the lead wires 5 are hermetically sealed. The jig 7 comprises an externally threaded base 8 of machined steel, a brass probe 9 fixedly mounted thereon, an inner rubber sleeve 10 having a tapered bore for holding the lead wires 5 in electrical contact with the probe 9 and an internally screw threaded outer sleeve 11 of machined steel which surrounds the lead wires 5. The outer sleeve 11 is chamfered to guide insertion of the lead wires 5 into the assembled jig 7 and is provided with a beading 12. Each of the plating apertures 2 in the mask 1 is stepped so that the same can be fitted onto the cap 4 of a header 3 and the beading 12 of the associated jig 7, the cap 4 then being just proud of the mask surface. In use, headers 3 are first barrel plated with nickel, then loaded manually or automatically into jigs 7 which are rigidly interconnected in groups corresponding to the number of plating apertures 2 in a mask 1 by means of plate members (not shown). A mask 1 is then press fitted to each group of jigs 7 and to the headers 3 mounted therein so as to expose only the end face of the cap 4 and the ends of the lead wires 5 of each header 3. The whole assembly is then inverted over a plating tank in a selective plating machine, clamped in position either pneumatically, hydraulically or mechanically and selective plating is carried out. The mask 1 is peeled away from the header 3 after plating.

In normal use of a header 3, a chip is soldered to the end face of the cap 4 and connected electrically to one or more of the ends of the lead wires 5. Thus, it is only necessary for a part, for example half, of the end face of the cap 4 to be plated with gold. This can be effected using a further mask having D-shaped plating apertures which is applied after the first mask 1. In order to ensure that the correct part of the end face of the cap 4 of each header 3 is plated, the headers 3 are orientated during loading by means of tabs 13.

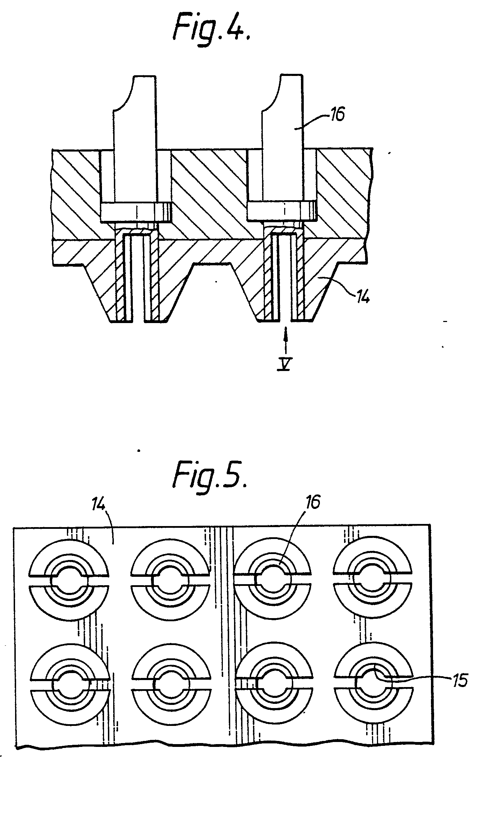

Referring now to Figures 3 to 5 inclusive, the second mask 14 comprises a silicone rubber (supplied by Dow Corning) having a hardness of about 70° shore and is provided with a plurality of plating apertures 15. Figures 4 and 5 illustrate the use of the second mask 14 for selective plating military-type sockets 16, such that selective plating is achieved on the inner surface (where it is required) and not on the outer surface. The plating apertures 15 are slotted in the same manner as the sockets, thus allowing electrolyte to flow over the inner surface to be selectively plated.

## Claims

1. A method of selective plating a plurality of components, which method comprises mounting each component on a jig (7) so that the plurality of components are fixed in position relative to one another, and then press-fitting a resilient mask (1) havivg a plurality of apertures (2) onto the components, wherein each component is located in relation to the mask (1) by contacting the jig (7) with the mask (1), so that each aperture (2) resiliently engages a respective said component and selectively exposes a portion thereof, each aperture (2) comprising first and second portions of respective different cross-sectional areas, a part of the respective component being engaged in the first portion, and a beading of the jig being engaged in the second portion of the aperture.

2. A method according to Claim 1, wherein the mask comprises a silicone rubber.

3. A method according to Claim 1 or 2, wherein the mask comprises a material having a hardness of from 12° to 80° shore.

4. A method according to any one of the preceding claims, wherein the component comprises an IC header.

5. A method according to any one of the preceding claims, wherein the component is selectively plated with gold.

6. A method according to any one of the preceding claims, further comprising the step of reducing the selectively exposed portion of each component by applying a further mask having an aperture.

7. A method according to any one of the preceding claims, wherein the component is selectively jet-plated.

**Patentansprüche**

1. Verfahren zum selektiven Plattieren einer Mehrzahl von Bauteilen, gekennzeichnet durch Anbringen jedes Bauteils auf einer Haltevorrichtung (7), so daß die Mehrzahl von Bauteilen relativ zueinander in ihrer Position fixiert ist und anschließendes Preßpassen einer elastischen Maske (1) mit einer Mehrzahl von Öffnungen (2) auf die Bauteile, wobei jedes Bauteil durch In-Kontakt-Bringen der Haltevorrichtung (7) mit der Maske (1) in Bezug zur Maske (1) so fixiert wird, daß jede Öffnung (2) elastisch mit einem entsprechenden besagten Bauteil in Eingriff kommt und selektiv einen Teil desselben offenlegt, wobei jede Öffnung (2) einen ersten und einen zweiten Abschnitt von entsprechend unterschiedlicher Querschnittsfläche aufweist, wobei ein Teil des entsprechenden Bauteils mit dem ersten Abschnitt und eine Wulst der Haltevorrichtung mit dem zweiten Abschnitt der Öffnung in Eingriff kommt.

2. Verfahren nach Anspruch 1, dadurch gekennzeichnet, daß die Maske einen Silikonkautschuk umfaßt.

3. Verfharen nach Anspruch 1 oder 2, dadurch gekennzeichnet, daß die Maske ein Material mit einer Shore-Härte von 12° bis 80° umfaßt.

4. Verfahren nach einem der vorangehenden Ansprüche, dadurch gekennzeichnet, daß das Bauteil einen IC-Sockel umfaßt.

5. Verfahren nach einem der vorangehenden Ansprüche, dadurch gekennzeichnet, daß das Bauteil selektiv mit Gold plattiert wird.

6. Verfahren nach einem der vorangehenden Ansprüche, gekennzeichnet durch den weiteren Schritt des Verringerns des selektiv offengelegten Teils jedes Bauteils durch Aufbringen einer weiteren Maske mit einer Öffnung.

7. Verfahren nach einem der vorangehenden Ansprüche, dadurch gekennzeichnet, daß das Bauteil selektiv düsenstrahlplattiert wird.

**Revendications**

1. Procédé pour déposer, par placage sélectif, un revêtement sur une pluralité de composants, ce procédé incluant le montage de chaque composant sur un gabarit (7) de telle sorte que les différents composants sont fixés dans des positions relatives les uns par rapport aux autres, puis la fixation, selon un ajustement serré, d'un masque élastique (1) possédant une pluralité d'ouvertures (2), sur les composants, et selon lequel chaque composant est situé par rapport au masque (1), sous l'effet de la mise en contact du gabarit (7) avec le masque (1), de telle sorte que chaque ouverture (2) est élastiquement en contact avec l'un desdits composants et laisse sélectivement à nu une partie de ce dernier, chaque ouverture (2) comportant des première et seconde parties possédant des surfaces respectives différentes en coupe transversale et une partie du composant respectif s'engageant dans la première partie, tandis qu'un talon du gabarit s'engage dans la seconde partie de l'ouverture.

2. Procédé selon la revendication 1, selon lequel le masque est formé par du caoutchouc silicone.

3. Procédé selon la revendication 1 ou 2, selon lequel le masque possède une dureté Shore comprise entre 12° et 80°.

4. Procédé selon l'une quelconque des revendications précédentes, selon lequel le composant comprend une embase d'un circuit intégré.

5. Procédé selon l'une quelconque des revendications précédentes, selon lequel on recouvre le composant au moyen d'un placage sélectif d'or.

6. Procédé selon l'une quelconque des revendications précédentes, incluant en outre l'étape consistant à réduire la partie, mise à nu de façon sélective, de chaque composant au moyen de l'application d'un masque supplémentaire comportant une ouverture.

7. Procédé selon l'une quelconque des revendications précédentes, selon lequel on soumet le composant à un placage sélectif par projection.

*Fig.1.*

*Fig.3.*

# Fig. 2.

Fig.4.

Fig.5.